**Europäisches Patentamt**

**European Patent Office**

**Office européen des brevets**

(19)

(11) Veröffentlichungsnummer : **0 057 258**
**B1**

# (12) EUROPÄISCHE PATENTSCHRIFT

(45) Veröffentlichungstag der Patentschrift :
26.09.84

(21) Anmeldenummer : 81108437.5

(22) Anmeldetag : 16.10.81

(51) Int. Cl.³ : **H 01 L 21/31, H 01 L 21/306**

(54) **Verfahren zum Herstellen von Polysiliziumstrukturen im 1/um-Bereich auf integrierte Halbleiterschaltungen enthaltenden Substraten durch Plasmaätzen.**

(30) Priorität : 30.01.81 DE 3103177

(43) Veröffentlichungstag der Anmeldung :
11.08.82 Patentblatt 82/32

(45) Bekanntmachung des Hinweises auf die Patenterteilung : 26.09.84 Patentblatt 84/39

(84) Benannte Vertragsstaaten :
**BE FR GB NL**

(56) Entgegenhaltungen :
**IEEE ELECTRON DEVICES, Band ED-27, Nr. 8, August 1980 NEW YORK (US) N. ENDO u. a. : "1 microm-MOS process using anisotropic dry etching" Seiten 1346-1351**
**JOURNAL OF THE ELECTROCHEMICAL SOCIETY, Band 79-2, 14-19 Oktober 1979 PRINCETON (US) R.A. GDULA: "SF6Rie of polysilicon" Seiten 1524-1526**

(73) Patentinhaber : **Siemens Aktiengesellschaft Berlin und München Wittelsbacherplatz 2 D-8000 München 2 (DE)**

(72) Erfinder : **Beinvogl, Willy, Dr. rer. nat. Tutzinger Strasse 3 D-8000 München 70 (DE)**
Erfinder : **Hasler, Barbara Engertstrasse 17 D-8035 Stockdorf (DE)**

## Beschreibung

Die vorliegende Patentanmeldung betrifft ein Verfahren zum Herstellen von Polysiliziumstrukturen im 1 μm-Bereich auf integrierte Halbleiterschaltungen enthaltenden, mit einer $SiO_2$-Schicht bedeckten Substraten durch Plasmaätzen in einem Plattenreaktor mit einem reaktiven Gasgemisch aus Schwefelhexafluorid ($SF_6$) und Inertgas.

Für die Herstellung von Strukturen in Polysiliziumschichten für die Fertigung von hochintegrierten Halbleiterschaltungen werden heute hauptsächlich reaktive Trockenätzverfahren verwendet. Diese Trockenätzverfahren werden bei Polysiliziumschichten häufig im Tunnelreaktor mit Tetrafluorkohlenstoff ($CF_4$) als Ätzgas und Sauerstoff durchgeführt. Ein Nachteil dieses Verfahrens ist das Auftreten von Unterätzungen wie beim Naßätzen (chemisches Ätzen) sowie ein ungleichmäßiger Ätzangriff. Man ist deshalb beim Trockenätzen auf die Verwendung von Plattenreaktoren anstelle von Tunnelreaktoren übergegangen. Für unkritische Prozeßschritte, das heißt bei großen Strukturen oder ganzflächigen Überätzen findet der Tunnelreaktor nach wie vor Verwendung.

Bei der Verwendung von Plattenreaktoren unterscheidet man zwei Ätzverfahren :

1. das Plasmaätzen, bei dem die zu ätzenden Substrate auf der geerdeten Elektroden liegen und als reaktives Gas $CF_4$ oder Fluor-Chlor-Mischgase verwendet werden. Der Gasdruck beträgt 50 bis 150 Pa. Solche Verfahren sind aus dem ECS Spring Meeting 1980, Seiten 274 bis 276 aus einer Veröffentlichung von H. Mader oder aus dem J. Vac. Sci. Technol. 17 (3) May/June 1980 auf den Seiten 721 bis 730 aus einem Aufsatz von C. J. Mogab und H. J. Levinstein zu entnehmen.

2. Das reaktive Sputterätzen oder Ionenätzen, bei dem die zu ätzenden Substrate auf die HF-führende Elektrode gelegt werden und als reaktives Gas Schwefelhexafluorid ($SF_6$) mit Stickstoff oder Helium als Trägergas verwendet wird. Solche Verfahren sind aus dem ECS Fall Meeting 1979, Seite 1524-1526 aus einem Aufsatz von R. A. Gdula oder aus IEEE Transactions und Electron Devices, Vol. ED-27, Nr. 8, August 1980, Seiten 1346-1351 aus einem Aufsatz von Endo und Kurogi zu entnehmen.

Diese Verfahren haben den Nachteil einer zu geringen Gleichmäßigkeit des Ätzangriffs, einer zu geringen Selektivität oder erzeugen hohe Unterätzungen, so daß ein Einsatz in für die Fertigung von integrierten Halbleiterschaltkreisen geeigneten großen Plattenreaktoren nicht möglich ist.

Die Erfindung dient deshalb zur Lösung der Aufgabe, ein Trockenätzverfahren zur Herstellung von Polysiliziumstrukturen bis in den Bereich von 1 μm für hochintegrierte Halbleiterschaltungen anzugeben, welches in einem einstufigen Prozeßablauf eine hohe Selektivität des Ätzens und eine gute Gleichmäßigkeit des Ätzangriffs erzielt, wobei auch ein hoher Durchsatz an Siliziumscheiben, das heißt, eine gute Auslastung des Reaktors gewährleistet ist.

Diese Aufgabe wird durch ein Verfahren der eingangs genannten Art dadurch gelöst, daß erfindungsgemäß die zu ätzenden, mit der Polysiliziumschicht und einer Ätzmaske aus Fotolack versehenen Substrate auf der geerdeten Elektrode des Plattenreaktors angeordnet werden, daß die Hochfrequenzleistung P auf Werte kleiner 0,1 Watt/cm², der Gasdruck P des reaktiven Gases im Reaktor im Bereich von 60 bis 120 Pa, die Elektrodentemperatur (T) im Bereich von 20 bis 60 °C und der Gasfluß (Q) von Inertgas : $SF_6$ auf Werte kleiner als 5 : 1 eingestellt wird.

Durch die Einstellung einer extrem niedrigen HF-Leistung (sie liegt im Normalfall um den Faktor 10 höher), insbesondere im Bereich von 0,03 bis 0,09 Watt/cm² wird erreicht, daß die Wärmebelastung der geätzten Kristallschichten sehr gering gehalten wird, so daß die auftretenden Strahlenschäden minimal sind.

Gegenüber den bekannten Verfahren hat das Verfahren nach der Lehre der Erfindung den Vorteil, daß es in einem einstufigen Prozeßschritt ohne Änderungen der Ätzbedingungen während des Plasmaätzens durchgeführt werden kann und daß der verwendete Plattenreaktor bei Einhaltung der optimalen Prozeßparameter voll ausgelastet werden kann.

Gemäß einem besonders günstigen Ausführungsbeispiel nach der Lehre der Erfindung wird bei einem Plattenabstand der Elektroden von 20 ± 5 mm und bei einem Elektrodendurchmesser von 60 cm die HF-Leistung P auf 200 Watt, der Gasfluß Q Helium : $SF_6$ auf 2 : 1 (das heißt 25 ccm/min $SF_6$ und 50 ccm/min He), der Gasdruck auf 70 bis 75 Pa und die Elektrodentemperatur auf 30 bis 40 °C eingestellt.

Weitere Einzelheiten des erfindungsgemäßen Verfahrens sind aus den Figuren 1 bis 4 zu entnehmen. Dabei zeigt :

die Figur 1 in einer Prinzipskizze den zur Durchführung des Verfahrens vorgesehenen Plattenreaktor, welcher als rotationssymmetrische Anlage mit thermostatisierten Aluminiumelektroden ausgeführt ist,

die Figur 2 und 3 zeigen im Kurvendiagramm die Ätzraten und Selektivitäten als Funktion der HF-Leistung P bzw. der HF-Leistungsdichte r (Figur 2) und als Funktion des Druckes p (Figur 3),

die Figur 4 zeigt im Schnittbild eine nach dem erfindungsgemäßen Verfahren geätzte Dreischichtenanordnung : Fotolack-Polysilizium-$SiO_2$-Siliziumkristall.

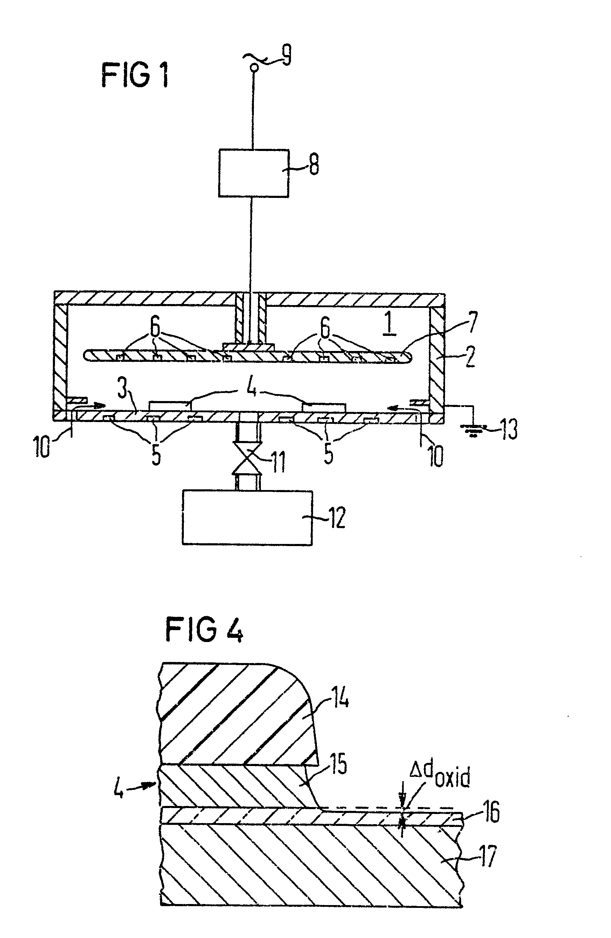

Gemäß Figur 1 besteht der Reaktor 1 aus einem Gehäuse 2 aus zum Beispiel Aluminium, dessen Bodenplatte 3 aus Aluminium als Elektrode für die Kristallscheiben 4 verwendet wird. Diese Elektrode 3 ist mit einem Leitungssystem 5 versehen und an einen Wasserkreislauf (in der Figur nicht dargestellt) zur Einstellung der Elektrodentemperatur angeschlossen. Ein solches Leitungssystem 6 befindet sich auch in der im Abstand von 20 mm gegenüberliegenden Aluminiumelektrode 7, welche über ein Abstimmungsnetzwerk 8 mit einem HF-Generator 9 von 13,56 MHz verbunden ist. Im äußeren Bereich der Bodenplatte 3 befinden sich die Einlässe 10 für das aus $SF_6$ und Helium bestehende Prozeßgas. Die gasförmigen Reaktionsprodukte werden aus dem Reaktor 1 über ein Drosselventil 11 zur automatischen Druckregelung mittels einer Rotationspumpe 12 abgesaugt. Die als Elektrode dienende Bodenplatte 3, auf welcher die mit den zu ätzenden Oberflächen versehenen Substraten 4 liegen, ist geerdet (siehe Bezugszeichen 13).

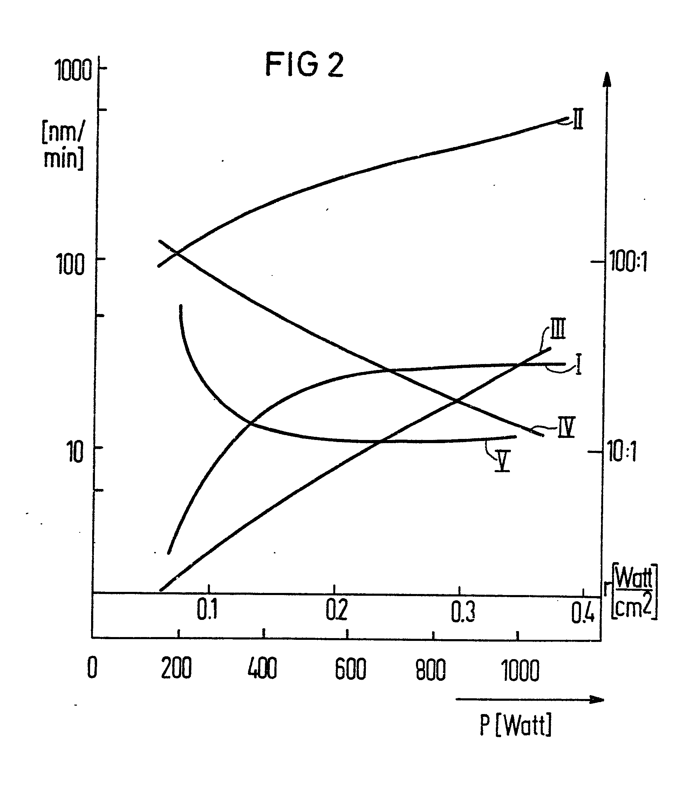

In der Figur 2 ist als linke Ordinate die Ätzrate in nm/min und als rechte Ordinate die Selektivität aufgetragen. Als Abszisse ist die HF-Leistung P in Watt und darüber die Leistungsdichte r in $Watt/cm^2$ aufgetragen. Dabei zeigt die Kurve I die Abhängigkeit der Ätzrate von der HF-Leistung von Fotolack (AZ 1 350 von Shipley), die Kurve II die von Polysilizium und die Kurve III die von $SiO_2$ unter Verwendung von $SF_6$ und Helium als Reaktionsgas bei einem Gasdruck von 70 Pa. Die Kurve IV zeigt die Selektivität Polysilizium : $SiO_2$ und die Kurve V die Selektivität Polysilizium : Fotolack (AZ 1 350).

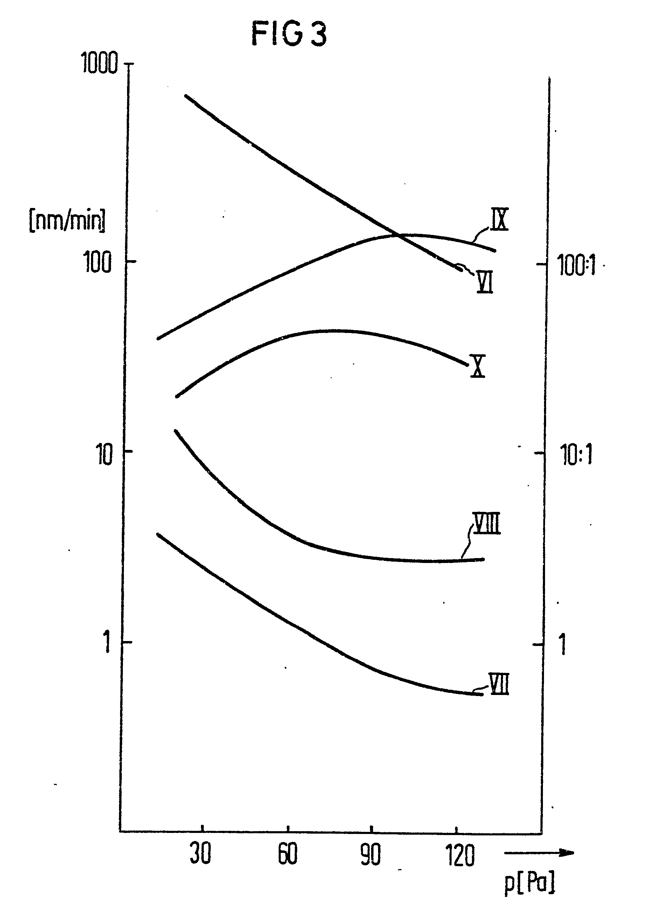

In der Figur 3 ist als Abszisse der Gasdruck p in Pa aufgetragen, als linke Ordinate die Ätzrate in nm/min und als rechte Ordinate die Selektivität. Die Kurve VI zeigt die Abhängigkeit der Ätzrate von p für Polysilizium, die Kurve VII die Abhängigkeit der Ätzrate von p für $SiO_2$, die Kurve VIII die Abhängigkeit der Ätzrate von p für den Fotolack, die Kurve IX stellt die Selektivität Polysilizium : $SiO_2$ und die Kurve X die Selektivität Polysilizium : Fotolack dar. Die Kurven gelten für eine HF-Leistung von 200 Watt.

Wie aus den Kurvendiagrammen von Figur 2 und 3 zu entnehmen ist, liegen die Selektivitäten Polysilizium zu $SiO_2 > 100 : 1$ und Polysilizium zu Fotolack $> 40 : 1$, wenn eine HF-Leistung von 200 Watt (siehe Figur 2) und ein Gasdruck von 70 bis 75 Pa (siehe Figur 3) eingestellt wird. Der Gasfluß Q soll auf 25 ccm/min $SF_6$ und 50 ccm/min Helium gehalten werden ; der Plattenabstand beträgt 20 mm ; die Temperatur für die obere Elektrode wird auf 40 °C bis 45 °C, die der unteren Elektrode auf 30 °C eingestellt.

Die außergewöhnlich hohen Werte der Selektivitäten garantieren einen sehr geringen Oxidabtrag $sd_{ox}$ der sehr dünnen (40 nm dick) $SiO_2$-Schicht 16 von < 2 nm unter der Polysiliziumschicht 15, wie aus dem in Figur 4 dargestellten Schnittbild zu entnehmen ist, sowie eine gute Maßhaltigkeit der Fotolackstrukturen 14, auch bei sehr schrägen Flanken. Mit dem Bezugszeichen 17 ist der Grundkörper der integrierten Halbleiterschaltung aus Silizium bezeichnet.

Aufgrund der Potentialverhältnisse im Plasma ist der Ätzvorgang gemischt isotrop-anisotrop. Die Unterätzung pro Kante liegt für eine 500 nm dicke P-dotierte Polysiliziumschicht 15 bei 150 nm. Die Unterätzung pro Kante schwankt bei einer Kristallscheibe von 100 mm Durchmesser um weniger als ± 0,1 μm. Diese Homogenität des Ätzangriffs über den ganzen Reaktor (beladen mit maximal 19 Kristallscheiben) ist vergleichsweise sehr gut (Schwankung < 3 %) und wirkt sich auf die elektrischen Eigenschaften von VLSI-Bauelementen, die mit diesem Verfahren hergestellt wurden, sehr positiv aus.

Die Kontrolle über den Ätzprozeß ist über die Ätzzeit (ca. 9 Minuten für 500 nm Polysilizium bei voller Belegung) oder über die Intensitätsänderung einer Emissionslinie des Plasmas möglich.

## Ansprüche

1. Verfahren zum Herstellen von Polysiliziumstrukturen im 1 μm-Bereich auf integrierte Halbleiterschaltungen enthaltenden, mit einer $SiO_2$-Schicht bedeckten Substraten durch Plasmaätzen in einem Plattenreaktor mit einem reaktiven Gasgemisch aus Schwefelhexafluorid ($SF_6$) und Inertgas, dadurch gekennzeichnet, daß die zu ätzenden, mit einer Polysiliziumschicht (15) und einer Ätzmaske (14) aus Fotolack versehenen Substrate (4) auf der geerdeten Elektrode (3) des Plattenreaktors (1) angeordnet werden, daß die Hochfrequenzleistung (P) auf Werte kleiner 0,1 $Watt/cm^2$, der Gasdruck (p) des reaktiven Gases im Reaktor im Bereich von 60-120 Pa, die Elektrodentemperatur (T) im Bereich von 20 bis 60 °C und der Gasfluß (Q) von Inertgas : $SF_6$ auf Werte kleiner 5 : 1 eingestellt wird.

2. Verfahren nach Anspruch 1, dadurch gekennzeichnet, daß die Hochfrequenzleistung (P) auf 0,03 bis 0,09 $Watt/cm^2$ eingestellt wird.

3. Verfahren nach Anspruch 1 und 2, dadurch gekennzeichnet, daß als Inertgas Helium verwendet wird.

4. Verfahren nach Anspruch 1 bis 3, dadurch gekennzeichnet, daß der Plattenabstand (a) der Elektroden (3, 7) auf 20 ± 5 mm eingestellt wird (Figur 1).

5. Verfahren nach Anspruch 1 bis 4, dadurch gekennzeichnet, daß bei einem Elektrodendurchmesser (3, 7) von 60 cm die HF-Leistung (P) auf 200 Watt, der Gasfluß Q He : $SF_6$ auf 2 : 1, der Gasdruck (p) auf 70-75 Pa, der Plattenabstand (a) auf 20 mm und die Elektrodentemperatur (T) auf 30-40 °C eingestellt wird (Figur 1).

6. Verfahren nach Anspruch 1 bis 5, dadurch gekennzeichnet, daß als Plattenreaktor (1) eine rotationssymmetrische Anlage mit thermostatisierten Aluminiumelektroden (3, 7) verwendet wird (Figur 1).

## Claims

1. A method of manufacturing polysilicon structures having dimensions in the region of 1 μm on substrates comprising integrated semiconductor circuits and which are covered with an $SiO_2$-layer, by plasma etching in a plate reactor using a reactive gas mixture consisting of sulphur hexafluoride (SF$_6$) and inert gas, characterised in that the substrates (4) which are to be etched and which are provided with a polysilicon layer (15) and an etching mask (14) made of photo-lacquer, are arranged on the earthed electrode (3) of the plate reactor (1) ; that the high-frequency power (P) is set at values which are less than 0.1 watt/cm$^2$, the gas pressure (p) of the reactive gas in the reactor is set in the range of 60-120 Pa, the electrode temperature (T) is set in the range of 20 to 60 °C, and the gas flow (Q) of inert gas : SF$_6$ is set at values which are smaller than 5 : 1.

2. A method according to Claim 1, characterised in that the high-frequency power (P) is set to 0.03 to 0.09 watt/cm$^2$.

3. A method according to Claim 1 and 2, characterised in that helium is used as inert gas.

4. A method according to Claim 1 to 3, characterised in that the plate gap (a) of the electrodes (3, 7) is set at 20 ± 5 mm, (Figure 1).

5. A method according to Claim 1 to 4, characterised in that for an electrode diameter (3, 7) of 60 cm, the HF-power (P) is set at 200 watts, the gas flow Q He : SF$_6$ at 2 : 1, the gas pressure (p) at 70 to 75 Pa, the plate gap (a) at 20 mm, and the electrode temperature (T) at 30 to 40 °C (Figure 1).

6. A method according to Claim 1 to 5, characterised in that a rotationally symmetrical arrangement having thermostatically-controlled aluminium electrodes (3, 7) is used as a plate reactor (1), (Figure 1).

**Revendications**

1. Procédé de fabrication de structures en silicium polycristallin ayant une dimension de l'ordre de micron, sur des substrats revêtus d'une couche de SiO$_2$ et comportant des circuits intégrés à semiconducteurs par attaque par plasma, dans un réacteur à plaques, avec un mélange gazeux réactif d'hexafluorure de soufre (SF$_6$) et de gaz inerte, caractérisé en ce qu'il consiste à disposer les substrats (4) à attaquer munis d'une couche (15) de silicium polycristallin et d'un masque de gravure (14) en vernis photosensible sur l'électrode (3) mise à la terre du réacteur à plaques (1), à régler la puissance en haute fréquence (P) à des valeurs inférieures à 0,1 watt/cm$^2$, la pression (P) du gaz réactif dans le réacteur dans la plage allant de 60 à 120 Pa, la température des électrodes (T) dans la plage allant de 20 à 60 °C, et le rapport des débits (Q) de gaz inerte : SF$_6$ à des valeurs inférieures à 5 : 1.

2. Procédé suivant la revendication 1, caractérisé en ce qu'il consiste à régler la puissance en haute fréquence (P) entre 0,03 et 0,09 watt/cm$^2$.

3. Procédé suivant les revendications 1 et 2, caractérisé en ce qu'il consiste à utiliser de l'hélium comme gaz inerte.

4. Procédé suivant les revendications 1 à 3, caractérisé en ce qu'il consiste à régler l'écartement des plaques (a) des électrodes (3, 7) à 20 ± 5 mm (figure 1).

5. Procédé suivant les revendications 1 à 4, caractérisé en ce qu'il consiste à régler, pour un diamètre d'électrodes (3, 7) de 60 cm, la puissance HF (P) à 200 watt, le rapport des débits des gaz Q He : SF$_6$ à 2 : 1, la pression du gaz (p) entre 70 et 75 Pa, l'écartement des plaques (a) à 20 mm et la température des électrodes (T) entre 30 et 40 °C (figure 1).

6. Procédé suivant les revendications 1 à 5, caractérisé en ce qu'il consiste à utiliser, comme réacteur à plaques (1), une installation à symétrie de rotation à électrodes (3, 7) en aluminium thermostatées (figure 1).

FIG 1

FIG 4

FIG 2

# FIG 3